# EUROPÄISCHE PATENTSCHRIFT

(11) **EP 3 983 762 B1**
(45) Veröffentlichungstag und Bekanntmachung des Hinweises auf die Patenterteilung: **12.04.2023**
(21) Anmeldenummer: 20723859.3
(22) Anmeldetag: 06.05.2020
(51) Int. Cl.: G01F 23/296, G01N 11/16, G01F 1/66, G01N 9/00

(54) **VIBRONISCHER MULTISENSOR**
VIBRONIC MULTISENSOR
MULTICAPTEUR VIBRONIQUE

(30) Priorität: 13.06.2019 DE 102019116152
(43) Veröffentlichungstag der Anmeldung: 20.04.2022
(73) Patentinhaber: Endress+Hauser SE+Co. KG, 79689 Maulburg (DE)
(72) Erfinder: KUHNEN, Raphael, 79418 Schliengen (DE); BRENGARTNER, Tobias, 79312 Emmendingen (DE); LOPATIN, Sergey, 79540 Lörrach (DE); SCHLEIFERBÖCK, Jan, 79595 Rümmingen (DE); SPRINGMANN, Thorsten, 79688 Hausen (DE)
(74) Vertreter: Koslowski, Christine Adelheid
(86) Internationale Anmeldenummer: PCT/EP2020/062523
(87) Internationale Veröffentlichungsnummer: WO 2020/249319

(56) Entgegenhaltungen:
- EP-A1- 0 984 248
- DE-A1- 3 149 909
- DE-A1- 10 350 084
- DE-A1-102016 112 309
- DE-B3-102006 045 654
- US-A- 4 299 114

## Beschreibung

Die Erfindung betrifft eine Vorrichtung zur Bestimmung und/oder Überwachung von zumindest einer Prozessgröße eines Mediums umfassend eine Sensoreinheit mit einer mechanisch schwingfähigen Einheit, zumindest einem ersten und einem zweiten piezoelektrischen Element, einer Einheit zur Bestimmung und/oder Überwachung der Temperatur des Mediums und mit einer Elektronik. Ferner betrifft die vorliegende Erfindung ein Verfahren zur Bestimmung und/oder Überwachung von zumindest einer Prozessgröße eines Mediums. Das Medium befindet sich in einem Behältnis, beispielsweise in einem Behälter oder in einer Rohrleitung.

Vibronische Sensoren finden vielfach Anwendung in der Prozess- und/oder Automatisierungstechnik. Im Falle von Füllstandsmessgeräten weisen sie zumindest eine mechanisch schwingfähige Einheit, wie beispielsweise eine Schwinggabel, einen Einstab oder eine Membran auf. Diese wird im Betrieb mittels einer Antriebs-/Empfangseinheit, häufig in Form einer elektromechanischen Wandlereinheit, zu mechanischen Schwingungen angeregt, welche wiederum beispielsweise ein piezoelektrischer Antrieb oder ein elektromagnetischer Antrieb sein kann. Entsprechende Feldgeräte werden von der Anmelderin in großer Vielfalt hergestellt und beispielsweise unter der Bezeichnung LIQUIPHANT oder SOLIPHANT vertrieben. Die zugrundeliegenden Messprinzipien sind im Prinzip aus einer Vielzahl von Veröffentlichungen bekannt. Die Antriebs-/Empfangseinheit regt die mechanisch schwingfähige Einheit mittels eines elektrischen Anregesignals zu mechanischen Schwingungen an. Umgekehrt kann die Antriebs-/Empfangseinheit die mechanischen Schwingungen der mechanisch schwingfähigen Einheit empfangen und in ein elektrisches Empfangssignal umwandeln. Bei der Antriebs-/Empfangseinheit handelt es sich entsprechend entweder um eine separate Antriebseinheit und eine separate Empfangseinheit, oder um eine kombinierte Antriebs-/Empfangseinheit.

Dabei ist die Antriebs-/Empfangseinheit in vielen Fällen Teil eines rückgekoppelten elektrischen Schwingkreises, mittels welchem die Anregung der mechanisch schwingfähigen Einheit zu mechanischen Schwingungen erfolgt. Beispielsweise muss für eine resonante Schwingung die Schwingkreisbedingung, gemäß welcher der Verstärkungsfaktor ≥1 ist und alle im Schwingkreis auftretenden Phasen ein Vielfaches von 360° ergeben, erfüllt sein. Zur Anregung und Erfüllung der Schwingkreisbedingung muss eine bestimmte Phasenverschiebung zwischen dem Anregesignal und dem Empfangssignal gewährleistet sein. Deshalb wird häufig ein vorgebbarer Wert für die Phasenverschiebung, also ein Sollwert für die Phasenverschiebung zwischen dem Anregesignal und dem Empfangssignal eingestellt. Hierfür sind aus dem Stand der Technik unterschiedlichste Lösungen, sowohl analoge als auch digitale Verfahren, bekannt geworden, wie beispielsweise in den Dokumenten DE102006034105A1, DE102007013557A1, DE102005015547A1, DE102009026685A1, DE102009028022A1, DE102010030982A1 oder DE00102010030982A1 beschrieben.

Sowohl das Anregesignal als auch das Empfangssignal sind charakterisiert durch ihre Frequenz ω, Amplitude A und/oder Phase Φ. Entsprechend werden Änderungen in diesen Größen üblicherweise zur Bestimmung der jeweiligen Prozessgröße herangezogen. Bei der Prozessgröße kann es sich beispielsweise um einen Füllstand, einen vorgegebenen Füllstand, oder auch um die Dichte oder die Viskosität des Mediums, sowie um den Durchfluss handeln. Bei einem vibronischen Grenzstandschalters für Flüssigkeiten wird beispielsweise unterschieden, ob die schwingfähige Einheit von der Flüssigkeit bedeckt ist oder frei schwingt. Diese beiden Zustände, der Freizustand und der Bedecktzustand, werden dabei beispielsweise anhand unterschiedlicher Resonanzfrequenzen, also anhand einer Frequenzverschiebung, unterschieden.

Die Dichte und/oder Viskosität wiederum lassen sich mit einem derartigen Messgerät nur ermitteln, wenn die schwingfähige Einheit vom Medium bedeckt ist. Im Zusammenhang mit der Bestimmung der Dichte und/oder Viskosität sind ebenfalls unterschiedliche Möglichkeiten aus dem Stand der Technik bekannt geworden, wie beispielswiese die in den Dokumenten DE10050299A1, DE102007043811A1, DE10057974A1, DE102006033819A1, DE102015102834A1 oder DE102016112743A1 offenbarten.

Mit einem vibronischen Sensor lassen sich entsprechend mehrere Prozessgrößen bestimmen und für eine Charakterisierung des jeweiligen Prozesses heranziehen. In vielen Fällen werden für eine umfassende Prozessüberwachung und/oder -kontrolle allerdings weitere Informationen über den Prozess, insbesondere Kenntnis über weitere physikalische und/oder chemische Prozessgrößen und/oder-parameter benötigt. Dies kann beispielsweise durch die Integration weiterer Feldgeräte in den jeweiligen Prozess erreicht werden. Dann können die von den verschiedenen Messgeräten zur Verfügung gestellten Messwerte in einer den Geräten übergeordneten Einheit geeignet weiterverarbeitet werden.

Nun ist es aber so, dass die unterschiedlichen Messgeräte zum einen über unterschiedliche Messgenauigkeiten verfügen. Darüber hinaus können Drift- und/oder Alterungseffekte jeweils sehr unterschiedlich sein. Solche Effekte können aber die jeweilige Messung bzw. Prozessüberwachung und/oder -kontrolle erheblich erschweren bzw. ungenau machen. Darüber hinaus kann es schwierig sein, den jeweiligen Zustand der einzelnen Feldgeräte jeweils im fortlaufenden Betrieb festzustellen. So ist aus der bisher unveröffentlichten deutschen Patentanmeldung mit dem Aktenzeichen 102018127526.9 ein vibronischer Multisensor bekannt geworden, mittels welchem sowohl das vibronische Messprinzip als auch das Ultraschall-Messprinzip zur Bestimmung und/oder

Überwachung einer oder mehrerer Prozessgrößen möglich ist.

Die DE 31 49 909 A1 offenbart eine Vorrichtung zur Bestimmung und/oder Überwachung von zumindest einer Prozessgröße eines Mediums, umfassend eine Sensoreinheit mit einer starren Gabel mit zwei Zinken, einem ersten piezoelektrischen Element und einem zweiten piezoelektrischen Element, wobei das erste piezoelektrische Element in dem ersten Zinken und das zweite piezoelektrische Element in dem zweiten Zinken angeordnet ist. Das erste piezoelektrische Element ist dazu ausgestaltet, ein Ultraschallsignal auszusenden, und das zweite piezoelektrische Element ist dazu ausgestaltet, das Ultraschallsignal in Form eines Empfangssignals zu empfangen.

Ausgehend vom genannten Stand der Technik liegt der vorliegenden Erfindung die Aufgabe zugrunde, die Funktionalität eines vibronischen Sensors weiter zu vergrößern.

Diese Aufgabe wird gelöst durch das Vorrichtung nach Anspruch 1 sowie durch das Verfahren nach Anspruch 5.

Hinsichtlich der Vorrichtung wird die Aufgabe gelöst durch eine Vorrichtung zur Bestimmung und/oder Überwachung von zumindest einer Prozessgröße eines Mediums gemäß Anspruch 1, umfassend eine Sensoreinheit mit einer mechanisch schwingfähigen Einheit, zumindest einem ersten piezoelektrischen Element, und einer Einheit zur Bestimmung und/oder Überwachung einer Leitfähigkeit und/oder einer Kapazität des Mediums, und eine Elektronik. Die Vorrichtung ist dazu ausgestaltet, die mechanisch schwingfähige Einheit mittels eines Anregesignals zu mechanischen Schwingungen anzuregen, die mechanischen Schwingungen der schwingfähigen Einheit zu empfangen und in ein erstes Empfangssignal umzuwandeln, ein Sendesignal auszusenden, und ein zweites Empfangssignal zu empfangen. Die Elektronik ist wiederum dazu ausgestaltet, anhand des ersten und/oder zweiten Empfangssignals die zumindest eine Prozessgröße und anhand eines dritten, von der Einheit empfangenen Empfangssignals die Leitfähigkeit und/oder Kapazität des Mediums zu bestimmen.

Bei der mechanisch schwingfähigen Einheit handelt es sich um eine Schwinggabel. Die beiden piezoelektrischen Elemente dienen einerseits als Antriebs-/Empfangseinheit zur Erzeugung der mechanischen Schwingungen der mechanisch schwingfähigen Einheit, welche mittels des Anregesignals erzeugt werden. Die mechanischen Schwingungen wiederum werden im Falle, dass die schwingfähige Einheit von Medium bedeckt ist, von den Eigenschaften des Mediums beeinflusst, so dass anhand des ersten Empfangssignals, welches die Schwingungen der schwingfähigen Einheit repräsentiert, eine Aussage über die zumindest eine Prozessgröße generierbar ist.

Das erste piezoelektrische Element dient weiterhin der Erzeugung eines Sendesignals, welches in Form des zweiten Empfangssignals vom zweiten piezoelektrischen Element empfangen wird. Das Sendesignal ist erfindungsgemäß ein Ultrasachallsignal. Wenn das Sendesignal auf seinem Weg zumindest zeitweise und abschnittsweise das Medium durchläuft, wird es ebenfalls durch die physikalischen und/oder chemischen Eigenschaften des Mediums beeinflusst und kann entsprechend zur Bestimmung einer Prozessgröße des Mediums herangezogen werden.

Somit ist es im Rahmen der vorliegenden Erfindung möglich, zumindest zwei Messprinzipien in einer einzigen Vorrichtung zu realisieren. Die Sensoreinheit führt einerseits mechanische Schwingungen aus; zudem wird ein Sendesignal ausgesendet. In Reaktion auf die mechanischen Schwingungen und auf das Sendesignal werden zwei Empfangssignale empfangen und können beispielsweise hinsichtlich zumindest zwei unterschiedlicher Prozessgrößen ausgewertet werden. Die beiden Empfangssignale können dabei vorteilhaft unabhängig voneinander ausgewertet werden. So kann erfindungsgemäß die Anzahl ermittelbarer Prozessgrößen deutlich erhöht werden, was zu einer höheren Funktionalität des jeweiligen Sensors bzw. in einem erweiterten Anwendungsbereich resultiert.

Darüber hinaus umfasst die erfindungsgemäße Vorrichtung eine Einheit zur Bestimmung und/oder Überwachung der Leitfähigkeit und/oder Kapazität des Mediums. Diese Einheit umfasst beispielsweise eine Sensoreinheit, welche zur Erfassung zumindest einer dieser beiden Größen ausgestaltet ist. Die Sensoreinheit wird mittels eines weiteren, elektrischen Anregesignals angeregt und das dritte Empfangssignal von der Einheit empfangen. Aus dem dritten Empfangssignal kann dann die Leitfähigkeit und/oder Kapazität des Mediums als zumindest eine weitere Prozessgröße ermittelt werden. Durch die zusätzliche Information hinsichtlich der Leitfähigkeit und/oder Kapazität des Mediums kann der Anwendungsbereich des Multisensors demnach deutlich verbessert und die Funktionalität des Sensors erweitert werden.

Das erste und zweite piezoelektrische Element sind dazu ausgestaltet, die mechanisch schwingfähige Einheit mittels eines Anregesignals zu mechanischen Schwingungen anzuregen und die mechanischen Schwingungen der schwingfähigen Einheit zu empfangen und in ein erstes Empfangssignal umzuwandeln, wobei das erste piezoelektrische Element dazu ausgestaltet ist, ein Sendesignal auszusenden, und wobei das zweite piezoelektrische Element dazu ausgestaltet ist, das Sendesignal in Form eines zweiten Empfangssignals zu empfangen.

Es handelt sich bei der mechanisch schwingfähigen Einheit eine Schwinggabel mit einem ersten und einem zweiten Schwingelement, wobei das erste piezoelektrische Element zumindest teilweise in dem ersten Schwingelement und das zweite piezoelektrische Element zumindest teilweise in dem zweiten Schwingelement angeordnet ist. Entsprechende Ausgestaltungen einer Sensoreinheit sind beispielsweise in den Dokumenten DE102012100728A1 sowie in der bisher unveröffentlichten deutschen Patentanmeldung mit dem Aktenzeichen 102017130527.0 beschrieben worden. Bei den in den beiden Dokumenten beschriebenen möglichen Ausgestaltungen der Sensoreinheit handelt es sich um beispielhafte mögliche konstruktive Ausgestaltungen der Sensoreinheit.

Eine weitere Ausgestaltung der Vorrichtung beinhaltet, dass die Einheit zur Bestimmung und/oder Überwachung der Leitfähigkeit und/oder Kapazität des Mediums eine kapazitive und/oder konduktive Messsonde mit zumindest einer Sondenelektrode umfasst.

Die konduktiven und kapazitiven Messprinzipien sind aus dem Stand der Technik hinlänglich bekannt. Beim konduktiven Messprinzip wird beispielsweise überwacht, ob über das leitfähige Medium ein elektrischer Kontakt zwischen einer Sondenelektrode und der Wandung eines leitfähigen Behälters oder einer zweiten Elektrode besteht. Beim kapazitiven Messprinzip wird dagegen eine Kapazität des von einer Sondenelektrode und der Wandung des Behälters oder einer zweiten Elektrode gebildeten Kondensators ermittelt.

Aus dem Stand der Technik sind auch Multisensoren bekannt geworden, welche dazu in der Lage sind eine konduktive und eine kapazitive Messung durchzuführen, wie beispielsweise die in den Dokumenten DE102011004807A1, DE102013102055A1, DE102014107927A1 oder DE102013104781A1 beschrieben.

Es ist weiterhin von Vorteil, wenn die Messsonde eine Guardelektrode umfasst. Die Verwendung einer Guardelektrode dient beispielsweise zur Vermeidung eines störenden Einflusses von Ansatz im Bereich der Sensoreinheit auf die Messung und ist beispielsweise in der DE 32 12 434 C2 ausführlich beschrieben. Erweiternd wird in diesem Zusammenhang in der DE 10 2006 047 780 A1 eine Messsonde mit einer Verstärkungseinheit und einem Begrenzungselement beschrieben, die über einen großen Messbereich hinweg unempfindlich gegenüber Ansatzbildung ist. Zudem hat die DE 10 2008 043 412 A1 ein Füllstandsmessgerät mit einer Speichereinheit zum Gegenstand, auf welcher Grenzwerte für unterschiedliche Medien abgelegt sind.

Noch eine bevorzugte Ausgestaltung der Vorrichtung beinhaltet, dass die Sensoreinheit eine Einheit zur Bestimmung und/oder Überwachung eines Drucks und/oder eine Einheit zur Bestimmung und/oder Überwachung einer Temperatur des Mediums umfasst. Durch die Implementierung weiterer Messprinzipien in einem einzigen Sensor können der Applikationsbereich sowie die Messgenauigkeiten des Sensors noch weiter verbreitert bzw. erhöht werden.

Die der Erfindung zugrunde liegende Aufgabe wird ferner gelöst durch ein Verfahren zur

Bestimmung und/oder Überwachung zumindest einer Prozessgröße eines Mediums gemäß Anspruch 5.

Das Verfahren bezieht sich erfindungsgemäß auf eine Vorrichtung nach einer der zuvor beschriebenen Ausgestaltungen. Es ist einerseits denkbar, dass die Sensoreinheit gleichzeitig mittels des Anregesignals und mittels des Sendesignals beaufschlagt wird, wobei das Anregesignal und das Sendesignal einander überlagert werden. Alternativ kann die Sensoreinheit aber auch abwechselnd mittels des Anregesignal und mittels des Sendesignals beaufschlagt werden.

Bei dem Anregesignal handelt es sich beispielsweise um ein elektrisches Signal mit zumindest einer vorgebbaren Frequenz, insbesondere um ein sinusförmiges oder um ein rechteckförmiges Signal. Vorzugsweise wird die mechanisch schwingfähige Einheit zumindest zeitweise zu Resonanzschwingungen angeregt. Die mechanischen Schwingungen werden durch das die schwingfähige Einheit umgebende Medium beeinflusst, so dass anhand eines die Schwingungen repräsentierenden Empfangssignals Rückschlüsse auf verschiedene Eigenschaften des Mediums möglich sind.

Bei dem Sendesignal handelt es sich erfindungsgemäß um ein, insbesondere gepulstes, Ultraschallsignal, insbesondere um zumindest einen Ultraschallpuls. Als zweites angewendetes Messverfahren wird demnach im Rahmen der vorliegenden Erfindung eine Ultraschall-basierte Messung durchgeführt. Das jeweils ausgesendete Sendesignal durchläuft zumindest teilweise das Medium und wird von diesem in seinen Eigenschaften beeinflusst. Entsprechend können anhand des jeweils empfangenen zweiten Empfangssignals ebenfalls Rückschlüsse auf verschiedene Medien gezogen werden.

Mit dem erfindungsgemäßen Verfahren ist eine Vielzahl unterschiedlicher Prozessgrößen mittels unterschiedlicher Messprinzipien ermittelbar. Unterschiedliche Prozessgrößen lassen sich vorteilhaft unabhängig voneinander bestimmen, so dass eine umfassende Analyse des jeweiligen Prozesses mittels eines einzigen Messgeräts ermöglicht wird. Dadurch, dass dieselbe Sensoreinheit für mehrere Messverfahren zum Einsatz kommt, kann darüber hinaus die Genauigkeit der Messungen deutlich erhöht werden. Darüber hinaus kann anhand der verschiedenen Messprinzipien eine Zustandsüberwachung der Vorrichtung vorgenommen werden. In dieser Hinsicht sind zahlreiche Ausgestaltungen für das erfindungsgemäße Verfahren möglich, von denen einige bevorzugte Varianten nachfolgend angegeben werden.

Eine bevorzugte Ausgestaltung beinhaltet, dass zumindest zwei unterschiedliche Prozessgrößen ermittelt werden, wobei eine erste Prozessgröße anhand des ersten Empfangssignals ermittelt wird, und wobei eine zweite Prozessgröße anhand des zweiten Empfangssignals ermittelt wird.

Eine weitere bevorzugte Ausgestaltung beinhaltet, dass es sich bei der zumindest einen Prozessgröße um einen vorgebbaren Füllstand, die Dichte, die Viskosität, die Schallgeschwindigkeit oder eine aus zumindest einer dieser Größen abgeleitete Größe handelt. Besonders bevorzugt wird anhand des ersten Empfangssignals die Dichte des Mediums und anhand des zweiten Empfangssignals die Schallgeschwindigkeit innerhalb des Mediums bestimmt. Es versteht sich jedoch von selbst, dass neben den hier explizit genannten Prozessgrößen auch weitere Prozessgrößen und/oder -parameter, welche mittels der beiden durchgeführten Messungen zugänglich sind, ebenfalls bestimmt und für eine Charakterisierung des jeweiligen Prozesses herangezogen werden können.

Eine Ausgestaltung des erfindungsgemäßen Verfahrens beinhaltet, dass anhand der Schallgeschwindigkeit ein Referenzwert für die Dichte ermittelt wird, wobei der Referenzwert mittels eines aus dem ersten Empfangssignals ermittelten Wertes für die Dichte verglichen wird. Vorzugsweise wird anhand der aus dem zweiten Empfangssignal ermittelten Schallgeschwindigkeit eine Konzentration einer in einem Referenzmedium gelösten Referenzsubstanz in einem vorgebbaren Behälter ermittelt. Aus der Konzentration kann anschließend der Referenzwert für die Dichte des Referenzmediums ermittelt werden. Zudem kann ein Messwert für die Dichte aus dem ersten Empfangssignal ermittelt werden. Die beiden Werte für die Dichte können dann miteinander verglichen werden. Insbesondere kann der aus dem ersten Empfangssignal ermittelte Wert für die Dichte anhand des aus dem zweiten Empfangssignals ermittelten Referenzwerts für die Dichte justiert werden. Auf diese Weise kann eine nachteilige Beeinflussung der Geometrie des jeweils verwendeten Behältnisses auf die vibronische Bestimmung der Dichte kompensiert werden.

Noch eine bevorzugte Ausgestaltung beinhaltet, dass eine elektrische Impedanz und/oder eine Dielektrizitätskonstante des Mediums ermittelt wird/werden. Die elektrische Impedanz und/oder die Dielektrizitätskonstante lassen sich anhand des dritten Empfangssignals ermitteln. Hierzu dient insbesondere eine Einheit zur Bestimmung und/oder Überwachung der Leitfähigkeit und/oder Kapazität des Mediums.

Eine besonders bevorzugte Ausgestaltung des erfindungsgemäßen Verfahrens sieht vor, dass ein zeitlicher Verlauf zumindest einer elektrischen Leitfähigkeit des Mediums, der Dielektrizitätskonstanten des Mediums und/oder eines Bedeckungsgrades einer Einheit zur Bestimmung und/oder Überwachung der Leitfähigkeit und/oder Kapazität des Mediums aufgezeichnet wird, wobei anhand des zeitlichen Verlaufs der Leitfähigkeit, der Dielektrizitätskonstanten und/oder des Bedeckungsgrades zumindest ein in einem das Medium enthaltenden Behältnisses ablaufender Prozess überwacht wird. Bei dem Prozess kann es sich beispielsweise um einen Mischprozess oder um einen Reinigungsprozess handeln. In dieser Hinsicht sei auf die DE102017111393A1 verwiesen, auf welche im Rahmen der vorliegenden Erfindung vollumfänglich, insbesondere mit Hinblick auf das genannte Verfahren, Bezug genommen wird.

Noch eine besonders bevorzugte Ausgestaltung beinhaltet, dass anhand des ersten und zweiten Empfangssignals und/oder anhand der ersten und zweiten Prozessgröße eine erste Konzentration einer ersten in dem Medium enthaltenen Substanz und eine zweite Konzentration einer zweiten in dem Medium enthaltenen Substanz ermittelt wird. Gemäß Stand der Technik sind für eine derartige Analyse des Mediums auf zwei unterschiedliche Substanzen hin in der Regel zwei separate Messgeräte erforderlich, welche unterschiedliche Messgrößen bereitstellen. Erfindungsgemäß kann dagegen mittels einer einzigen Vorrichtung zuverlässig eine Aussage über zwei unterschiedliche Komponenten in einem Medium getätigt werden.

Eine bevorzugte Verwendung des Verfahrens betrifft die Überwachung eines Gärprozesses. Bei einer Gärung wird Zucker in Ethanol umgewandelt. Um eine qualitative Überwachung gewährleisten zu können, ist es deshalb erforderlich, sowohl die Konzentration von Zucker als auch von Ethanol zu bestimmen. Dies ist im Rahmen der vorliegenden Erfindung möglich.

Schließlich beinhaltet eine vorteilhafte Ausgestaltung des Verfahrens, dass anhand des ersten und zweiten Empfangssignals und/oder anhand der ersten und zweiten Prozessgröße ermittelt wird, ob sich ein Ansatz an der Sensoreinheit gebildet hat und/oder ob eine Drift und/oder Alterung der Sensoreinheit vorliegt. Die beiden Empfangssignale verhalten sich üblicherweise jeweils unterschiedlich in Abhängigkeit eines Ansatzes an der Sondeneinheit, einer Drift oder einer Alterung im Bereich der Sensoreinheit. Das Vorhandensein eines Ansatzes, einer Drift oder einer Alterung kann entsprechend beispielsweise anhand einer zeitlichen Betrachtung der beiden Empfangssignale und/oder Prozessgrößen festgestellt werden.

Es ist von Vorteil, wenn das erste und zweite Empfangssignal, die erste und zweite Prozessgröße und/oder ein zeitlicher Verlauf des ersten und zweiten Empfangssignals und/oder der ersten und zweiten Prozessgröße miteinander verglichen werden. Aus dem Vergleich kann dann auf das Vorhandensein eines Ansatzes, auf eine Drift oder eine Alterung der Sensoreinheit geschlossen werden. Da zumindest zwei Empfangssignale bzw. Prozessgrößen zugänglich sind, kann eine hohe Genauigkeit hinsichtlich der jeweils getroffenen Aussagen über einen Ansatz, eine Drift oder eine Alterung erzielt werden. Durch die erfindungsgemäße Realisierung zweier unterschiedlicher Messungen mit einer einzigen Sensoreinheit kann entsprechend das Vorhandensein von Ansatz, oder auch einer Drift oder eine Alterung der Sensoreinheit zuverlässig erkannt werden.

Noch eine bevorzugte Ausgestaltung des Verfahrens beinhaltet, dass anhand der Leitfähigkeit, Kapazität, elektrischen Impedanz und/oder Dielektrizitätskonstanten des Mediums, anhand zumindest einer aus zumindest einer dieser Größen abgeleiteten Größe oder anhand eines zeitlichen Verlaufs zumindest einer dieser Größen ermittelt wird ob sich ein Ansatz an der Sensoreinheit gebildet hat und/oder ob eine Drift und/oder eine Alterung der Sensoreinheit vorliegt.

Dabei ist es von Vorteil, wenn eine anhand des ersten und zweiten Empfangssignals und/oder anhand der ersten und zweiten Prozessgröße ermittelte erste Aussage und eine anhand der Leitfähigkeit, Kapazität, elektrischen Impedanz und/oder Dielektrizitätskonstanten des Mediums, anhand zumindest einer aus zumindest einer dieser Größen abgeleiteten Größe und/oder anhand eines zeitlichen Verlaufs zumindest einer dieser Größen ermittelte zweite Aussage über einen Ansatz an der Sensoreinheit und/oder einer Drift und/oder einer Alterung der Sensoreinheit miteinander verglichen werden. Auf diese Weise kann eine Aussage über einen Ansatz eine Drift und/oder eine Alterung der Sensoreinheit redundant bestimmt werden und ggf. ein Plausibilitätscheck durchgeführt werden.

So ist es von Vorteil, wenn anhand des Vergleichs eine Zustandsüberwachung zumindest einer Komponente der Sensoreinheit durchgeführt wird.

In einer weiteren bevorzugten Ausgestaltung wird ein Einfluss eines Ansatzes einer Drift und/oder einer Alterung der Sensoreinheit zumindest auf das erste und/oder zweite Empfangssignal reduziert oder kompensiert. Der Einfluss eines Ansatzes, einer Drift und/oder Alterung der Sensoreinheit kann demnach bei der Bestimmung und/oder Überwachung der jeweiligen Prozessgröße berücksichtigt werden, so dass die jeweilige Prozessgröße ohne auf dem Vorhandensein eines Ansatzes, einer Drift und/oder Alterung bestimmt werden kann. Zur Reduzierung oder zur Kompensation des Einflusses kann beispielsweise ein geeigneter, insbesondere prozessabhängiger, Algorithmus hinterlegt werden, anhand dessen ein nicht durch den Einfluss des Ansatzes, der Drift und/oder Alterung der Sensoreinheit verfälschter Wert für die jeweilige Prozessgröße ermittelbar ist. Somit kann eine verbesserte Messgenauigkeit erreicht sowie eine Möglichkeit zur vorausschauenden Wartung (engl. predictive maintenance) bereitgestellt werden.

In noch einer bevorzugten Ausgestaltung wird eine Dicke und/oder eine Leitfähigkeit eines Ansatzes an der Sensoreinheit ermittelt wird. Die Dicke und/oder die Leitfähigkeit des Ansatzes kann beispielsweise anhand der ermittelten Leitfähigkeit sowie eines Verhältnisses eines Messsignals der Sondenelektrode und der Guardelektrode ermittelt werden.

Es sei ferner darauf verwiesen, dass die im Zusammenhang mit der erfindungsgemäßen Vorrichtung beschriebenen Ausgestaltungen sich mutatis mutandis auch auf das erfindungsgemäße Verfahren anwenden lassen und umgekehrt.

Die Erfindung wird anhand der nachfolgenden Figuren näher erläutert. Es zeigt:
Fig. 1: eine schematische Skizze eines vibronischen Sensors gemäß Stand der Technik,
Fig. 2 mehrere mögliche, an sich aus dem Stand der Technik bekannte, Ausgestaltungen einer Sensoreinheit, welche zur Durchführung des erfindungsgemäßen Verfahrens geeignet sind, und
Fig. 3 eine mögliche Ausgestaltung einer erfindungsgemäßen Vorrichtung.

In den Figuren sind gleiche Elemente jeweils mit demselben Bezugszeichen versehen.

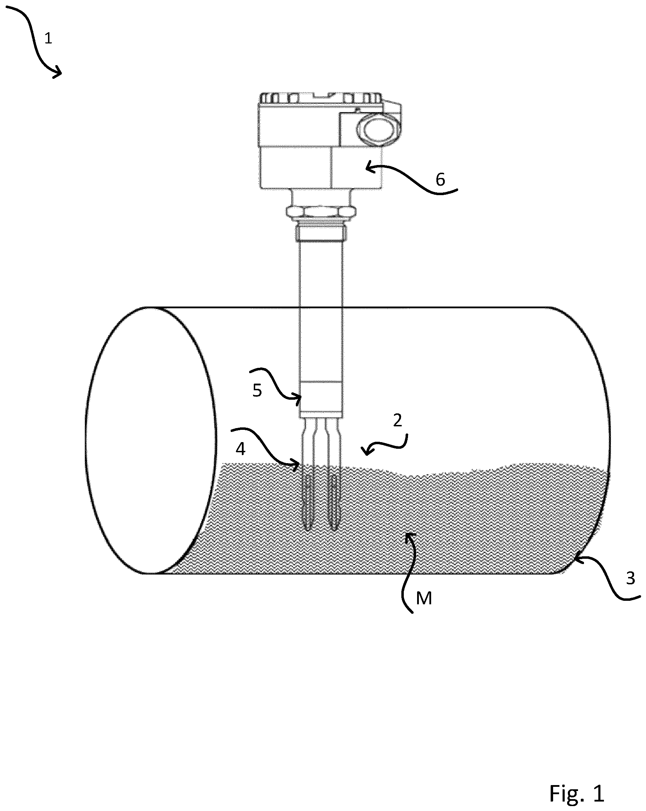

In Fig. 1 ist ein vibronischer Sensor 1 mit einer Sensoreinheit 2 gezeigt. Der Sensor verfügt über eine mechanisch schwingfähige Einheit 4 in Form einer Schwinggabel, welche teilweise in ein Medium M eintaucht, welches sich in einem Behälter 3 befindet. Die schwingfähige Einheit 4 wird mittels der Anrege-/Empfangseinheit 5 zu mechanischen Schwingungen angeregt, und kann beispielsweise durch einen piezoelektrischen Stapel- oder Bimorphantrieb sein. Andere vibronische Sensoren verfügen beispielsweise über elektromagnetische Antriebs-/Empfangseinheiten 5. Es ist sowohl möglich, eine einzige Antriebs-/Empfangseinheit 5 zu verwenden, welche zur Anregung der mechanischen Schwingungen sowie zu deren Detektion dient. Ebenso ist es aber denkbar, je eine Antriebseinheit und eine Empfangseinheit zu realisieren. Dargestellt ist in Fig. 1 ferner eine Elektronikeinheit 6, mittels welcher die Signalerfassung, -auswertung und/oder-speisung erfolgt.

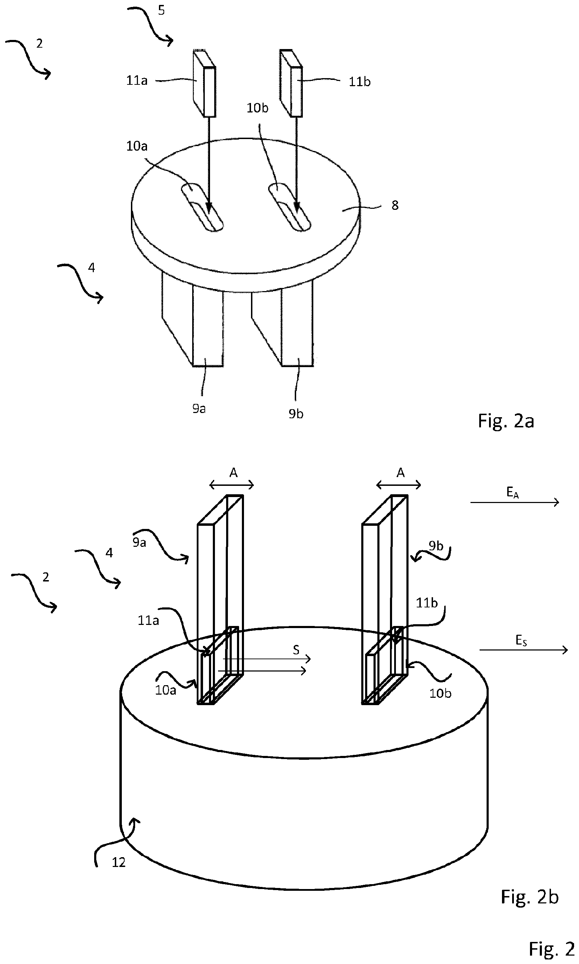

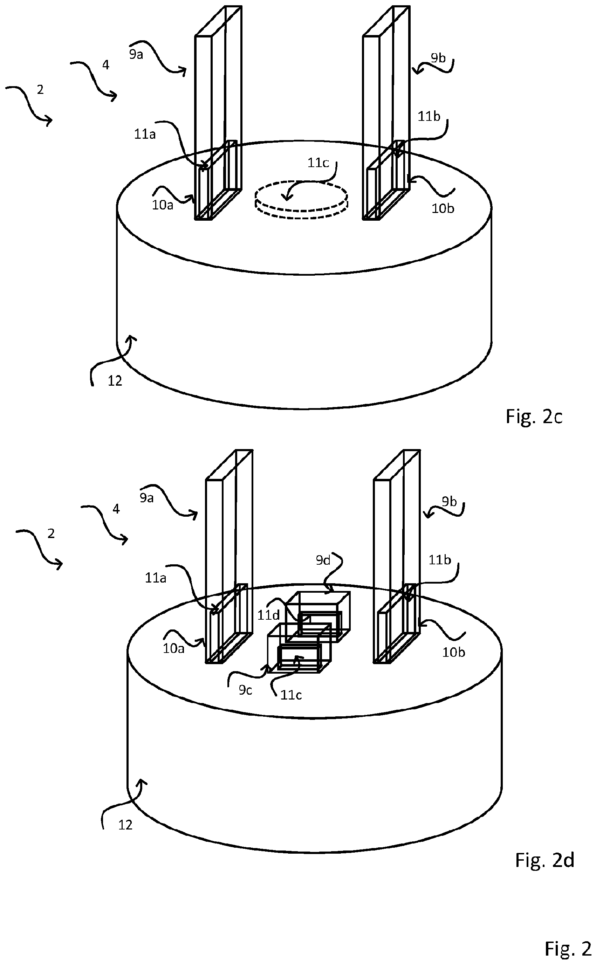

In Fig. 2 sind beispielhaft verschiedene Sensoreinheiten 2 gezeigt, welche sich zur Durchführung eines erfindungsgemäßen Verfahrens eignen. Die in Fig. 2a gezeigte mechanisch schwingfähige Einheit 4 umfasst zwei an einer Basis 8 angebrachte Schwingelemente 9a,9b, welche mithin auch als Gabelzinken bezeichnet werden. Optional kann an den Endseiten der beiden Schwingelemente 9a,9b außerdem jeweils ein Paddel angeformt sein [hier nicht gezeigt]. In jedem der beiden Schwingelemente 9a,9b ist jeweils ein, insbesondere taschenartiger, Hohlraum 10a, 10b eingebracht, in welchem jeweils zumindest ein piezoelektrisches Element 11a, 11b der Antriebs-/Empfangseinheit 5 angeordnet ist. Vorzugsweise sind die piezoelektrischen Elemente 11a und 11b innerhalb der Hohlräume 10a und 10b vergossen. Die Hohlräume 10a, 10b können dabei so beschaffen sein, dass sich die beiden piezoelektrischen Elemente 11a, 11b vollständig oder teilweise im Bereich der beiden Schwingelemente 9a, 9b befinden Eine solche sowie ähnliche Anordnungen sind in der DE102012100728A1 ausführlich beschrieben.

Eine weitere beispielhafte, mögliche Ausgestaltung einer Sensoreinheit 2 ist in Fig. 2b dargestellt. Die mechanisch schwingfähige Einheit 4 verfügt über zwei parallel zueinander ausgerichtete, hier stabförmig ausgestaltete, auf einem scheibenförmigen Element 12 angebrachte, Schwingelemente 9a, 9b, welche getrennt voneinander zu mechanischen Schwingungen anregbar sind, und bei denen die Schwingungen ebenfalls getrennt voneinander empfangen und ausgewertet werden können. Beide Schwingelemente 9a und 9b weisen jeweils einen Hohlraum 10a und 10b auf, in welchen im dem scheibenförmigen Element 12 zugewandten Bereich jeweils zumindest ein piezoelektrisches Element 11a und 11b angeordnet ist. Bezüglich der Ausgestaltung gemäß Fig. 2b sei wiederum ferner auf in die bisher unveröffentlichte deutsche Patentanmeldung mit dem Aktenzeichen DE102017130527A1 verwiesen.

Wie in Fig. 2b schematisch eingezeichnet, wird erfindungsgemäß die Sensoreinheit 2 einerseits mit einem Anregesignal A beaufschlagt, derart, dass die schwingfähige Einheit 4 zu mechanischen Schwingungen angeregt wird. Die Schwingungen werden dabei vermittels der beiden piezoelektrischen Elemente 11a und 11b erzeugt. Es ist sowohl denkbar, dass beide piezoelektrischen Elemente mit demselben Anregesignal A beaufschlagt werden, als auch eine Beaufschlagung des ersten Schwingelements 11a mittels eines ersten Anregesignals A₁ und des zweiten Schwingelements 11b mittels eines zweiten Anregesignals A₂. Ebenso ist es sowohl denkbar, dass anhand der mechanischen Schwingungen ein erstes Empfangssignal E_{A}, oder von jedem Schwingelement 9a,9b ein separates Empfangssignal E_{A1} bzw. E_{A2} empfangen wird.

Darüber hinaus wird vom ersten piezoelektrischen Element 11a ausgehend ein Sendesignal S ausgesendet, welches von dem zweiten piezoelektrischen Element 11b in Form eines zweiten Empfangssignals Es empfangen wird. Da die beiden piezoelektrischen Elemente 11a und 11b zumindest im Bereich der Schwingelemente 9a und 9b angeordnet sind, durchläuft das Sendesignal S das Medium M, sofern die Sensoreinheit 2 mit dem Medium M in Kontakt ist und wird entsprechend von den Eigenschaften des Mediums M beeinflusst. Vorzugsweise handelt es sich bei dem Sendesignal S um ein, insbesondere gepulstes, Ultraschallsignal, insbesondere um zumindest einen Ultraschallpuls. Ebenso ist es aber denkbar, dass das Sendesignal S von dem ersten piezoelektrischen Element 11a im Bereich des ersten Schwingelements 9a ausgesendet wird und an dem zweiten Schwingelement 9b reflektiert wird. In diesem Falle wird das zweite Empfangssignal Es vom ersten piezoelektrischen Element 11a empfangen. Das Sendesignal S durchläuft in diesem Falle das Medium M zweimal, was zu einer Verdoppelung einer Laufzeit τ des Sendesignals S führt.

Neben diesen beiden gezeigten Ausgestaltungen einer erfindungsgemäßen Vorrichtung 1 sind noch zahlreiche weitere Varianten denkbar, welche ebenfalls unter die vorliegende Erfindung fallen. Beispielsweise ist es für die Ausgestaltungen gemäß der Figuren Fig. 2a und Fig. 2b möglich, lediglich ein piezoelektrisches Element 11a, 11b zu verwenden und zumindest in einem der beiden Schwingelemente 9a, 9b anzuordnen. In diesem Falle dient das piezoelektrische Element 9a zur Erzeugung des Anregesignals, und des Sendesignals S, sowie zum Empfangen des ersten E₁ und zweiten Empfangssignals E₂. Das Sendesignal wird in diesem Falle an dem zweiten Schwingelement 9b ohne piezoelektrisches Element 11b reflektiert.

Eine weitere, beispielhafte Möglichkeit ist in Fig. 2c dargestellt. Hier ist ein drittes piezoelektrisches Element 11c im Bereich der Membran 12 vorgesehen. Das dritte piezoelektrische Element 11c dient der Erzeugung des Anregesignals A und zum Empfangen des ersten Empfangssignals E₁; das erste 11a und zweite piezoelektrische Element 11b dienen der Erzeugung des Sendesignals S bzw. dem Empfangen des zweiten Empfangssignals E₂. Alternativ ist es beispielsweise möglich, mit dem ersten 11a und/oder zweiten piezoelektrischen Element 11b das Anregesignal A und das Sendesignal S zu erzeugen sowie das zweite Empfangssignal E₂ zu empfangen, wobei das dritte piezoelektrische Element 11c zum Empfangen des ersten Empfangssignals E₁ dient. Ebenso ist es möglich, mit dem ersten 11a und/oder zweiten piezoelektrischen Element 11b das Sendesignal S und mit dem dritten piezoelektrischen Element 11c das Anregesignal A zu erzeugen und mit dem ersten 11a und/oder zweiten piezoelektrischen Element 11b das erste E₁ und/oder zweite Empfangssignal E₂ zu empfangen. Auch im Falle der Fig. 2c ist es für andere Ausgestaltungen möglich, auf das erste 11a oder zweite piezoelektrische Element 11b zu verzichten.

Noch eine mögliche Ausgestaltung der Vorrichtung 1 ist Gegenstand von Fig. 2d. Die Vorrichtung umfasst ausgehend von der Ausgestaltung aus Fig. 2b ein drittes 9c und ein viertes Schwingelement 9d. Diese dienen jedoch nicht einer Schwingungserzeugung. Vielmehr ist in den zusätzlichen Elemente 9c, 9d jeweils ein drittes 11c und viertes piezoelektrisches Element 11d angeordnet. In diesem Falle wird die vibronische Messung mittels der ersten beiden piezoelektrischen Elemente 11a, 11b und die Ultraschallmessung mittels der anderen beiden piezoelektrischen Elemente 11c, 11d durchgeführt. Auch hier kann je Messprinzip auf ein piezoelektrisches Element, z. B. 11b und 11d verzichtet werden. Aus Symmetriegründen ist es dagegen vorteilhaft, stets zwei zusätzliche Schwingelemente 9c, 0d zu verwenden.

Das erste E_{A} und zweite Empfangssignal Es resultieren aus unterschiedlichen Messverfahren und können unabhängig voneinander hinsichtlich zumindest einer Prozessgröße P ausgewertet werden. In dieser Hinsicht sei auf die bisher unveröffentlichte deutsche Patentanmeldung mit dem Aktenzeichen 102018127526.9 verwiesen.

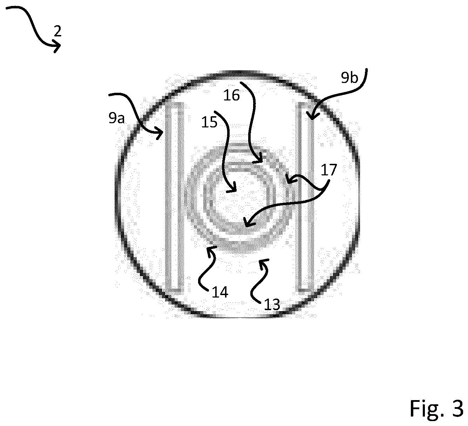

Darüber hinaus kann erfindungsgemäß die Leitfähigkeit σ und/oder Kapazität C des Mediums bestimmt und/oder überwacht werden. Hierzu verfügt die erfindungsgemäße Vorrichtung über eine Einheit 13 zur Bestimmung und/oder Überwachung der Leitfähigkeit σ und/oder Kapazität C mit einer kapazitiven und/oder konduktiven Messsonde 14, wie in Fig. 3 illustriert. In Fig. 3 ist eine Sensoreinheit 2 analog zur Ausgestaltung aus Fig. 2a gezeigt. Zwischen den beiden Schwingelementen 9a und 9b der in Form einer Schwinggabel ausgestalteten schwingfähigen Einheit 4 ist die Einheit 13 zur Bestimmung und/oder Überwachung der Leitfähigkeit σ und/oder Kapazität C des Mediums M mit der kapazitiv und konduktiv arbeitenden Messsonde 14 angeordnet, welche eine Sensorelektrode 15 und eine die Sensorelektrode 15 koaxial umgebende Guardelektrode 16 aufweist. Zwischen den beiden Elektroden 15 und 16 und zwischen der Messsonde 14 und der mechanisch schwingfähigen Einheit 4 sind jeweils isolierende Schichten 17 angeordnet.

### Bezugszeichenliste

- 1: Vibronischer Sensor
- 2: Sensoreinheit
- 3: Behälter
- 4: Schwingfähige Einheit
- 5: Antriebs-/Empfangseinheit
- 6: Elektronik
- 8: Basis
- 9a, 9b: Schwingelemente
- 10a, 10b: Hohlräume
- 11a, 11b: piezoelektrische Elemente
- 12: scheibenförmiges Element
- 13: Einheit zur Bestimmung und/oder Überwachung der Leitfähigkeit und/oder Kapazität
- 14: kapazitive und/oder konduktive Messsonde
- 15: Sensorelektrode
- 16: Guardelektrode
- 17: isolierende Schichten

- M: Medium
- P: Prozessgröße
- σ: Leitfähigkeit
- C: Kapazität
- A: Anregesignal
- S: Sendesignal
- E_{A}: erstes Empfangssignal
- Es: zweites Empfangssignal
- E_{L/C}: drittes Empfangssignal
- ΔΦ: vorgebbare Phasenverschiebung

## Patentansprüche

1. Vorrichtung (1) zur Bestimmung und/oder Überwachung von zumindest einer Prozessgröße (P) eines Mediums (M) umfassend
eine Sensoreinheit (2) mit
einer mechanisch schwingfähigen Schwinggabel (4) mit einem ersten (9a) und einem zweiten Schwingelement (9b),
zumindest einem ersten piezoelektrischen Element (11a) und einem zweiten piezoelektrischen Element (11b), wobei das erste piezoelektrische Element (11a) zumindest teilweise in dem ersten Schwingelement (9a) und das zweite piezoelektrische Element (11b) zumindest teilweise in dem zweiten Schwingelement (9b) angeordnet ist, wobei das erste (11a) und zweite piezoelektrische Element (11b) dazu ausgestaltet sind, die Schwinggabel (4) mittels eines Anregesignals (A) zu mechanischen Schwingungen anzuregen, die mechanischen Schwingungen der Schwinggabel (4) zu empfangen und in ein erstes Empfangssignal (E_{A}) umzuwandeln, wobei das erste piezoelektrische Element (11a) dazu ausgestaltet ist, ein Ultraschallsignal (S) auszusenden, und wobei das zweite piezoelektrische Element (11b) dazu ausgestaltet ist, das Ultraschallsignal (S) in Form eines zweiten Empfangssignals (Es) zu empfangen,
eine Einheit (13) zur Bestimmung und/oder Überwachung einer Leitfähigkeit (σ) und/oder Kapazität (C) des Mediums (M), und
eine Elektronik (6), die dazu ausgestaltet ist, anhand des ersten (E_{A}) und/oder zweiten Empfangssignals (Es) die zumindest eine Prozessgröße (P) und anhand eines dritten, von der Einheit (13) empfangenen Empfangssignals (E_{L/C}) die Leitfähigkeit (σ) und/oder Kapazität (C) des Mediums (M) zu bestimmen.

2. Vorrichtung (1) nach Anspruch 1,
wobei die Einheit (13) zur Bestimmung und/oder Überwachung der Leitfähigkeit (σ) und/oder Kapazität (C) des Mediums (M) eine kapazitive und/oder konduktive Messsonde (14) mit zumindest einer Sondenelektrode (15) umfasst.

3. Vorrichtung nach Anspruch 2,
wobei die Messsonde (14) eine Guardelektrode (16) umfasst.

4. Vorrichtung (1) nach zumindest einem der vorherigen Ansprüche,
wobei die Sensoreinheit (2) eine Einheit zur Bestimmung und/oder Überwachung eines Drucks (p) des Mediums (M) und/oder eine Einheit zur Bestimmung und/oder Überwachung einer Temperatur (T) des Mediums (M) umfasst.

5. Verfahren zur Bestimmung und/oder Überwachung von zumindest einer Prozessgröße (P) eines Mediums (M) mittels der Vorrichtung (1) nach zumindest einem der vorhergehenden Ansprüche, wobei
- die Sensoreinheit (2) mittels eines Anregesignals (A) zu mechanischen Schwingungen angeregt wird,
- die mechanischen Schwingungen von der Sensoreinheit (2) empfangen und in ein erstes Empfangssignal (E_{A}) umgewandelt werden,
- von dem ersten piezoelektrischen Element (11a) Ultraschallsignal (S) ausgesendet und ein zweites Empfangssignal (Eₛ) von dem zweiten piezoelektrischen Element (11b) empfangen wird, und
- anhand des ersten (E_{A}) und/oder zweiten Empfangssignals (Es) die zumindest eine Prozessgröße (P) und anhand eines dritten Empfangssignals (Euc) die Leitfähigkeit (σ) und/oder Kapazität (C) des Mediums (M) ermittelt wird.

6. Verfahren nach Anspruch 5,
wobei zumindest zwei unterschiedliche Prozessgrößen (P1, P2) ermittelt werden, wobei eine erste Prozessgröße (P1) anhand des ersten Empfangssignals (E_{A}) ermittelt wird, und wobei eine zweite Prozessgröße (P2) anhand des zweiten Empfangssignals (Es) ermittelt wird.

7. Verfahren nach zumindest einem der Ansprüche 5 oder 6,
wobei es sich bei der zumindest einen Prozessgröße (P) um einen vorgebaren Füllstand, die Dichte, die Viskosität, die Schallgeschwindigkeit oder eine aus zumindest einer dieser Größen abgeleitete Größe handelt.

8. Verfahren nach zumindest einem der Ansprüche 5-7,
wobei eine elektrische Impedanz und/oder eine Dielektrizitätskonstante des Mediums (M) ermittelt wird/werden.

9. Verfahren nach Anspruch 8,
wobei ein zeitlicher Verlauf zumindest einer elektrischen Leitfähigkeit (σ) des Mediums (M), der Dielektrizitätskonstante des Mediums (M) und/oder eines Bedeckungsgrades der Einheit (13) zur Bestimmung und/oder Überwachung der Leitfähigkeit (σ) und/oder Kapazität (C) des Mediums (M) aufgezeichnet wird, und
wobei anhand des zeitlichen Verlaufs der Leitfähigkeit (σ), der Dielektrizitätskonstanten und/oder des Bedeckungsgrades zumindest ein in einem das Medium (M) enthaltenden Behältnisses ablaufender Prozess überwacht wird.

10. Verfahren nach zumindest einem der Ansprüche 5-9,
wobei anhand des ersten (E_{A}) und zweiten Empfangssignals (Es) und/oder anhand der ersten (P1) und zweiten Prozessgröße (P2) eine erste Konzentration einer ersten in dem Medium (M) enthaltenen Substanz und eine zweite Konzentration einer zweiten in dem Medium (M) enthaltenen Substanz ermittelt wird.

11. Verfahren nach zumindest einem der Ansprüche 5-10,
wobei anhand des ersten (E_{A}) und zweiten Empfangssignals (Es) und/oder anhand der ersten (P1) und zweiten Prozessgröße (P2) ermittelt wird, ob sich ein Ansatz an der Sensoreinheit (2) gebildet hat und/oder ob eine Drift und/oder eine Alterung der Sensoreinheit (2) vorliegt.

12. Verfahren nach zumindest einem der Ansprüche 5-11,
wobei anhand der Leitfähigkeit (σ), Kapazität (C), elektrischen Impedanz und/oder Dielektrizitätskonstanten des Mediums (M), anhand zumindest einer aus zumindest einer dieser Größen abgeleiteten Größe und/oder anhand eines zeitlichen Verlaufs zumindest einer dieser Größen ermittelt wird ob sich ein Ansatz an der Sensoreinheit (2) gebildet hat und/oder ob eine Drift und/oder eine Alterung der Sensoreinheit (2) vorliegt.

13. Verfahren nach Anspruch 11 und 12,
wobei eine anhand des ersten (E_{A}) und zweiten Empfangssignals (Es) und/oder anhand der ersten (P1) und zweiten Prozessgröße (P2) ermittelte erste Aussage und eine anhand der Leitfähigkeit (σ), Kapazität (C), elektrischen Impedanz und/oder Dielektrizitätskonstanten des Mediums (M), anhand zumindest einer aus zumindest einer dieser Größen abgeleiteten Größe und/oder anhand eines zeitlichen Verlaufs zumindest einer dieser Größen ermittelte zweite Aussage über einen Ansatz an der Sensoreinheit (2) und/oder einer Drift und/oder einer Alterung der Sensoreinheit (2) miteinander verglichen werden.

14. Verfahren nach Anspruch 13,
wobei anhand des Vergleichs eine Zustandsüberwachung zumindest einer Komponente der Sensoreinheit (2) durchgeführt wird.

15. Verfahren nach zumindest einem der Ansprüche 5-14,
wobei ein Einfluss eines Ansatzes einer Drift und/oder einer Alterung der Sensoreinheit (2) zumindest auf das erste (E_{A}) und/oder zweite Empfangssignal (Es) reduziert oder kompensiert wird.

16. Verfahren nach zumindest einem der Ansprüche 5-15,
wobei eine Dicke und/oder eine Leitfähigkeit eines Ansatzes an der Sensoreinheit (2) ermittelt wird.

## Claims

1. Apparatus (1) designed to determine and/or monitor at least one process variable (P) of a medium (M) comprising
a sensor unit (2) with
a tuning fork (4) which is able to vibrate mechanically with
a first (9a) and a second vibrating element (9b),
at least a first piezoelectric element (11a) and a second piezoelectric element (11b), wherein the first piezoelectric element (11a) is arranged at least partially in the first vibrating element (9a) and the second piezoelectric element (11b) is arranged at least partially in the second vibrating element (9b), wherein the first (11a) and the second piezoelectric element (11b) are designed to excite the tuning fork (4) to perform mechanical vibrations by means of an excitation signal (A), to receive the mechanical vibrations of the tuning fork (4) and to convert them into a first reception signal (E_{A}), and wherein the first piezoelectric element (11a) is designed to emit an ultrasonic signal (S), and wherein the second piezoelectric element (11b) is designed to receive the ultrasonic signal (S) in the form of a second reception signal (Es),
a unit (13) designed to determine and/or monitor a conductivity (σ) and/or a capacitance (C) of the medium (M), and
an electronics unit (6), which is designed to determine the at least one process variable (P) using the first (E_{A}) and/or the second reception signal (Es), and to determine the conductivity (σ) and/or the capacitance (C) of the medium (M) using a third reception signal (E_{L/C}) received from the unit (13).

2. Apparatus (1) as claimed in Claim 1,
wherein the unit (13) designed to determine and/or monitor the conductivity (σ) and/or the capacitance (C) of the medium (M) comprises a capacitive and/or conductive (14) measuring probe with at least a probe electrode (15).

3. Apparatus (1) as claimed in Claim 2,
wherein the measuring probe (14) comprises a guard electrode (16).

4. Apparatus (1) as claimed in at least one of the previous claims,
wherein the sensor unit (2) comprises a unit to determine and/or monitor a pressure (p) of the medium (M) and/or a unit to determine and/or monitor a temperature (T) of the medium (M).

5. Procedure to determine and/or monitor at least one process variable (P) of a medium (M) using the apparatus (1) as claimed in at least one of the previous claims, wherein
- the sensor unit (2) is excited to perform mechanical vibrations by means of an excitation signal (A),
- wherein the mechanical vibrations are received by the sensor unit (2) and converted to a first reception signal (E_{A}),
- an ultrasonic signal (S) is emitted by the first piezoelectric element (11a) and a second reception signal (Es) is received by the second piezoelectric element (11b), and
- the at least one process variable (P) is determined using the first (E_{A}) and/or the second reception signal (Es), and the conductivity (σ) and/or the capacitance (C) of the medium (M) is determined using a third reception signal (E_{L/C}).

6. Procedure as claimed in Claim 5,
wherein at least two different process variables (P1, P2) are determined, wherein a first process variable (P1) is determined using the first reception signal (E_{A}), and a second process variable (P2) is determined using the second reception signal (Es).

7. Procedure as claimed in at least one of the Claims 5 or 6,
wherein the at least one process variable (P) is a predefinable level, the density, the viscosity, the sound velocity or a variable derived from at least one of these variables.

8. Procedure as claimed in at least one of the Claims 5 to 7,
wherein an electrical impedance and/or a dielectric constant of the medium (M) is/are determined.

9. Procedure as claimed in Claim 8,
wherein the development, over time, of at least an electrical conductivity (σ) of the medium (M), the dielectric constant of the medium (M) and/or a degree of coverage of the unit (13) to determine and/or monitor the conductivity (σ) and/or the capacitance (C) of the medium (M) is recorded, and wherein a process taking place in a vessel containing the medium (M) is monitored based on the development, over time, of the conductivity (σ), the dielectric constant and/or the degree of coverage.

10. Procedure as claimed in at least one of the Claims 5 to 9,
wherein, using the first (E_{A}) and the second reception signal (Es) and/or using the first (P1) and the second process variable (P2), a first concentration of a first substance contained in the medium (M) is determined and a second concentration of a second substance contained in the medium (M) is determined.

11. Procedure as claimed in at least one of the Claims 5 to 10,
wherein, using the first (E_{A}) and the second reception signal (Es) and/or using the first (P1) and the second process variable (P2), it is determined whether deposit buildup has formed on the sensor unit (2) and/or whether there is a drift and/or an aging of the sensor unit (2).

12. Procedure as claimed in at least one of the Claims 5 to 11,
wherein it is determined - on the basis of the conductivity (σ), the capacitance (C), the electrical impedance and/or the dielectric constant of the medium (M), on the basis of at least one variable derived from at least one of said variables and/or on the basis of a development, over time, of at least one of these variables - whether deposit buildup has formed on the sensor unit (2) and/or whether there is a drift and/or an aging of the sensor unit (2).

13. Procedure as claimed in Claims 11 and 12,
wherein a first statement determined using the first (E_{A}) and the second reception signal (Es) and/or using the first (P1) and the second process variable (P2) is compared with a second statement about deposit buildup on the sensor unit (2) and/or a drift and/or an aging of the sensor unit (2), which is determined using the conductivity (σ), the capacitance (C), the electrical impedance and/or the dielectric constant of the medium (M), using at least a variable derived from at least one of said variables and/or using a development, over time, of at least one of these variables.

14. Procedure as claimed in Claim 13,
wherein a condition monitoring of at least one component of the sensor unit (2) is performed on the basis of the comparison.

15. Procedure as claimed in at least one of the Claims 5 to 14,
wherein an influence of deposit buildup, a drift and/or an aging of the sensor unit (2) at least on the first (E_{A}) and/or the second reception signal (Es) is reduced or compensated.

16. Procedure as claimed in at least one of the Claims 5 to 15,
wherein a thickness and/or a conductivity of deposit buildup on the sensor unit (2) is determined.

## Revendications

1. Dispositif (1) destiné à la détermination et/ou à la surveillance d'au moins une grandeur de process (P) d'un produit (M) comprenant
une unité de capteur (2)
avec une fourche vibrante (4) apte à vibrer mécaniquement avec un premier (9a) et un deuxième élément vibrant (9b),
au moins un premier élément piézoélectrique (11a) et un deuxième élément piézoélectrique (11b), le premier élément piézoélectrique (11a) étant disposé au moins partiellement dans le premier élément vibrant (9a) et le deuxième élément piézoélectrique (11b) étant disposé au moins partiellement dans le deuxième élément vibrant (9b), le premier (11a) et le deuxième élément piézoélectrique (11b) étant conçus pour exciter la fourche vibrante (4) en vibrations mécaniques au moyen d'un signal d'excitation (A), recevoir les vibrations mécaniques de la fourche vibrante (4) et les convertir en un premier signal de réception (E_{A}), le premier élément piézoélectrique (11a) étant conçu pour émettre un signal ultrasonore (S), et le deuxième élément piézoélectrique (11b) étant conçu pour recevoir le signal ultrasonore (S) sous la forme d'un deuxième signal de réception (Es),
une unité (13) destinée à la détermination et/ou à la surveillance d'une conductivité (σ) et/ou une capacité (C) du produit (M), et
une électronique (6), laquelle est conçue pour déterminer, à l'aide du premier (E_{A}) et/ou du deuxième signal de réception (Es), l'au moins une grandeur de process (P) et, à l'aide d'un troisième signal de réception (E_{L/C}) reçu par l'unité (13), la conductivité (σ) et/ou la capacité (C) du produit (M).

2. Dispositif (1) selon la revendication 1,
pour lequel l'unité (13) destinée à la détermination et/ou à la surveillance de la conductivité (σ) et/ou de la capacité (C) du produit (M) comprend une sonde de mesure capacitive et/ou conductive (14) avec au moins une électrode de sonde (15).

3. Dispositif (1) selon la revendication 2,
pour lequel la sonde de mesure (14) comprend une électrode de garde (16).

4. Dispositif (1) selon l'une des revendications précédentes,
pour lequel l'unité de capteur (2) comprend une unité de détermination et/ou de surveillance d'une pression (p) du produit (M) et/ou une unité de détermination et/ou de surveillance d'une température (T) du produit (M).

5. Procédé destiné à la détermination et/ou à la surveillance d'au moins une grandeur de process (P) d'un produit (M) au moyen du dispositif (1) selon au moins l'une des revendications précédentes, procédé pour lequel
- l'unité de capteur (2) est excitée en vibrations mécaniques au moyen d'un signal d'excitation (A),
- les vibrations mécaniques sont reçues par l'unité de détection (2) et converties en un premier signal de réception (E_{A}),
- un signal ultrasonore (S) est émis par le premier élément piézoélectrique (11a) et un deuxième signal de réception (Es) est reçu par le deuxième élément piézoélectrique (11b), et
- à l'aide du premier (E_{A}) et/ou du deuxième signal de réception (Es), on détermine l'au moins une grandeur de process (P) et à l'aide d'un troisième signal de réception (E_{L/C}), la conductivité (σ) et/ou la capacité (C) du produit (M).

6. Procédé selon la revendication 5,
pour lequel au moins deux grandeurs de process différentes (P1, P2) sont déterminées, une première grandeur de process (P1) étant déterminée à l'aide du premier signal de réception (E_{A}), et une deuxième grandeur de process (P2) étant déterminée à l'aide du deuxième signal de réception (Es).

7. Procédé selon au moins l'une des revendications 5 ou 6,
pour lequel l'au moins une grandeur de process (P) est un niveau prédéfinissable, la densité, la viscosité, la vitesse du son ou une grandeur dérivée d'au moins l'une de ces grandeurs.

8. Procédé selon au moins l'une des revendications 5 à 7,
pour lequel on détermine une impédance électrique et/ou une constante diélectrique du produit (M).

9. Procédé selon la revendication 8,
pour lequel on enregistre une évolution dans le temps d'au moins une conductivité électrique (σ) du produit (M), de la constante diélectrique du produit (M) et/ou d'un degré de couverture de l'unité (13) de détermination et/ou de surveillance de la conductivité (σ) et/ou de la capacité (C) du produit (M), et
pour lequel on surveille, à l'aide de l'évolution dans le temps de la conductivité (σ), des constantes diélectriques et/ou du degré de couverture, au moins un process se déroulant dans un réservoir contenant le produit (M).

10. Procédé selon au moins l'une des revendications 5 à 9,
pour lequel on détermine, à l'aide du premier (E_{A}) et du deuxième signal de réception (Es) et/ou à l'aide de la première (P1) et de la deuxième grandeur de process (P2), une première concentration d'une première substance contenue dans le produit (M) et une deuxième concentration d'une deuxième substance contenue dans le produit (M).

11. Procédé selon au moins l'une des revendications 5 à 10,
pour lequel on détermine, à l'aide du premier (E_{A}) et du deuxième signal de réception (Es) et/ou à l'aide de la première (P1) et de la deuxième grandeur de process (P2), si un dépôt s'est formé sur l'unité de capteur (2) et/ou s'il y a une dérive et/ou un vieillissement de l'unité de capteur (2).

12. Procédé selon au moins l'une des revendications 5 à 11,
pour lequel on détermine à l'aide de la conductivité (σ), de la capacité (C), de l'impédance électrique et/ou de la constante diélectrique du produit (M), à l'aide d'au moins une grandeur dérivée d'au moins l'une de ces grandeurs et/ou à l'aide d'une évolution dans le temps d'au moins l'une de ces grandeurs, si un dépôt s'est formé sur l'unité de capteur (2) et/ou s'il existe une dérive et/ou un vieillissement de l'unité de capteur (2).

13. Procédé selon les revendications 11 et 12,
pour lequel une première affirmation déterminée à l'aide du premier (E_{A}) et du deuxième signal de réception (Es) et/ou à l'aide de la première (P1) et de la deuxième grandeur de process (P2) et une deuxième affirmation déterminée à l'aide de la conductivité (σ), de la capacité (C), de l'impédance électrique et/ou de la constante diélectrique du produit (M), à l'aide d'au moins une grandeur dérivée d'au moins l'une de ces grandeurs et/ou à l'aide d'une évolution dans le temps d'au moins l'une de ces grandeurs, on compare l'une à l'autre une deuxième affirmation concernant un dépôt sur l'unité de capteur (2) et/ou une dérive et/ou un vieillissement de l'unité de capteur (2).

14. Procédé selon la revendication 13,
pour lequel une surveillance de l'état d'au moins un composant de l'unité de capteur (2) est effectuée à l'aide de la comparaison.

15. Procédé selon au moins l'une des revendications 5 à 14,
pour lequel on réduit ou on compense une influence d'un dépôt, d'une dérive et/ou d'un vieillissement de l'unité de capteur (2) au moins sur le premier (E_{A}) et/ou le deuxième signal de réception (Es).

16. Procédé selon au moins l'une des revendications 5 à 15,
pour lequel on détermine une épaisseur et/ou une conductivité d'un dépôt sur l'unité de capteur (2).
